# EUROPEAN PATENT APPLICATION

(11) **EP 2 354 208 A1**
(43) Date of publication of application: **10.08.2011**
(21) Application number: 10152615.0
(22) Date of filing: 04.02.2010
(51) Int. Cl.: C09K 11/64, C09K 11/68, C09K 11/77

(54) **Luminescent material comprising chromium(III) doped yttrium aluminium borate**

(71) Applicant: Technische Universität Graz, 8010 Graz (AT); B. Braun Melsungen AG, 34212 Melsungen (DE)
(72) Inventor: Klimant, Ingo, 8200 Labuch (AT); Borisov, Sergey, 8010 Graz (AT); Gatterer, Karl, 8041 Graz (AT)
(74) Representative: Babeluk, Michael

(57) **Abstract**

The invention concerns a luminescent material exhibiting a temperature-dependent luminescence decay time, wherein the luminescent material comprises chromium(III) doped yttrium aluminium borate. The luminescent material meets the chemical formula YAl₃-ₓCrₓ(BO₃)₄ with 0.03 ≤ x ≤ 0.30, preferably 0.06 ≤ x ≤ 0.12. The luminescent material is preferably used as a temperature-sensitive component of a temperature-sensitive paint or coating or as a temperature sensing component of a temperature sensor.

## Description

### BACKGROUND OF THE INVENTION

The invention relates to a luminescent material (thermographic phosphor) exhibiting a temperature-dependent luminescence decay time.

### DESCRIPTION OF PRIOR ART

Temperature is one of the most important parameters to know in various fields of science and technology, and in everyday life. Contactless sensing is particularly attractive for various applications where invasiveness is undesirable.

Major contactless techniques include optical pyrometry, IR thermography and phosphor thermometry. Among them, optical pyrometry is only suitable for measurements at high temperatures (> 600 °C). On the other side, much lower temperatures and particularly those around room temperature (RT) are of great practical interest. For example, precise temperature determination is essential in marine research, geochemical studies, medicine, aeronautics, to mention only a few areas. Moreover, temperature is a key parameter in optical sensing since the response of virtually all such sensors is temperature-dependent. IR thermography has become very widespread but is still rather expensive and may suffer from various artifacts. Luminescent temperature-sensitive materials represent a promising alternative here. They respond to temperature by altering the luminescence intensity or the decay time. Thermographic phosphors are well established and have been in use for decades. However, most of them are intended for sensing high temperatures and become useless at ambient temperatures.

The suitable phosphors for RT sensing include e.g. manganese(IV)-doped magnesium fluorogermanate Mg₄FGeO₆, chromium(III)-doped yttrium-aluminium garnet Y₃Al₅O₁₂, aluminium oxide (ruby), spinel MgAl₂O₄ and yttrium-aluminium perovskite YAlO₃, as well as europium(III)-doped lanthanum oxysulphide La₂O₂S-Suitable RT sensing phosphors are disclosed e.g. in Brübach, J.; Feist, J. P.; Dreizler, A. "Characterization of manganese-activated magnesium fluorogermanate with regards to thermographic phosphor thermometry" Meas. Sci. Technol. 2008, 19, 025602 (11pp) and also in Aizawa, H.; Ohishi, N.; Ogawa, S.; Watanabe, E.; Katsumata, T.; Komuro, S.; Morikawa, T.; Toba, E. "Fabrication of ruby sensor probe for the fiber-optic thermometer using fluorescence decay" Rev. Sci. Instrum. 2002, 73, 3089-3092.

In Fuchs, E.; Gatterer, K. "Colour change of co-doped yttrium aluminium borate crystals under illumination with different white light sources" Cent. Eur. J. Chem. 2008, 6, 497-504 yttrium aluminium borate (YAB) crystals were co-doped with e.g. Cr and Nd or with Cr and Ho resulting in a colour change. A microcrystalline powder could be used as coating in order to produce a special colour changing effect. (See also WO 2007/128016 A2)

In US 6,303,386 B2 a device for the temperature-compensated determination of a chemical parameter is disclosed. The temperature sensor contains a temperature indicator comprising a luminescent metal complex containing ruthenium(II) having a temperature-dependent decay time.

Apart from thermographic phosphors, organo-metallic complexes which possess temperature-dependent luminescence were found to be very useful probes. Recently, they became increasingly popular and were applied in dually-sensing materials as shown for example in Borisov, S. M.; Wolfbeis, O. S. Anal. Chem. 2006, 78, 5094-5101 and in pressure-sensitive paints as disclosed in Demas, J. N.; DeGraff, B. A.; Coleman, P. B. Anal. Chem. 1999, 71, 793A-800A. Such materials usually rely on the use of ruthenium(II) polypyridyl complexes and europium(III) tris-β-diketonates. Not surprisingly, all these luminophors have their pros and cons and more advanced materials are highly desired.

### SUMMARY OF THE INVENTION

An "ideal" luminescent material for sensing temperature should fulfill the following requirements:
i) have high brightness;
ii) possess excitation in visible or NIR part of the spectrum;
iii) have high temperature sensitivity in the desired range;
iv) be photostable;
v) have negligible cross-sensitivity to other analytes such as e.g. oxygen;
vi) be commercially available or simple to manufacture; and
vii) have relatively long luminescence decay time (> 1 µs up to 100 ms) to lifetime interrogation.

It is an object of the present invention to present a new luminescent material, which fulfills the above mentioned requirements.

The invention achieves this object by a luminescent material which consist of or comprises chromium(III) doped yttrium aluminium borate (YAB). More preferably the material is based on solid state yttrium aluminium borate as a host matrix material with chromium(III) ions as dopant. Surprisingly chromium(III) doped yttrium aluminium borate (YAB) fulfills all requirements i) to vii) and is, therefore, a thermographic phosphor of choice for sensing of ambient temperatures.

According to the invention the luminescent material meets the chemical formula YAl₃-ₓCrₓ(BO₃)₄ with 0.03 ≤ x ≤ 0.30, preferably 0.06 ≤ x ≤ 0.12. That means about 1 to 10%, preferably 2 to 4% of aluminium ions are substituted by chromium ions.

According to a first preferred variant the luminescent material is a single crystal material, preferably obtained by high temperature flux growth from an oxide mixture comprising Y₂O₃, Al₂O₃, B₂O₃ and Cr₂O₃.

According to a second preferred variant the luminescent material is a micro crystalline powder, preferably obtained by a solution combustion synthesis, e.g. with urea as a fuel.

### BRIEF DESCRIPTION OF THE DRAWINGS

The invention will be further described below with reference to the enclosed drawings showing in
- Fig. 1: Emission spectra of the Cr³⁺ and Mn⁴⁺ -doped thermographic phosphors (λ_{exc} = 405 nm);
- Fig. 2: Excitation spectra of the Cr³⁺ and Mn⁴⁺ -doped thermographic phosphors;
- Fig. 3: Dependence decay time and luminescence intensity of the YAl₃-ₓCrₓ(BO₃)₄ powders on the amount of Cr³⁺;
- Fig. 4: Relative luminescence brightnesses (corrected emission spectra) of the Cr³+-doped thermographic phosphors (λ_{exc} = 405 nm);
- Fig. 5: Temperature dependence of the luminescence decay time for Cr³⁺ - doped YAB materials; and
- Fig. 6: Temperature sensitivities of the visible light-excitable thermographic phosphors.

### DETAILED DESCRIPTION OF THE PREFERRED EMBODIMENT

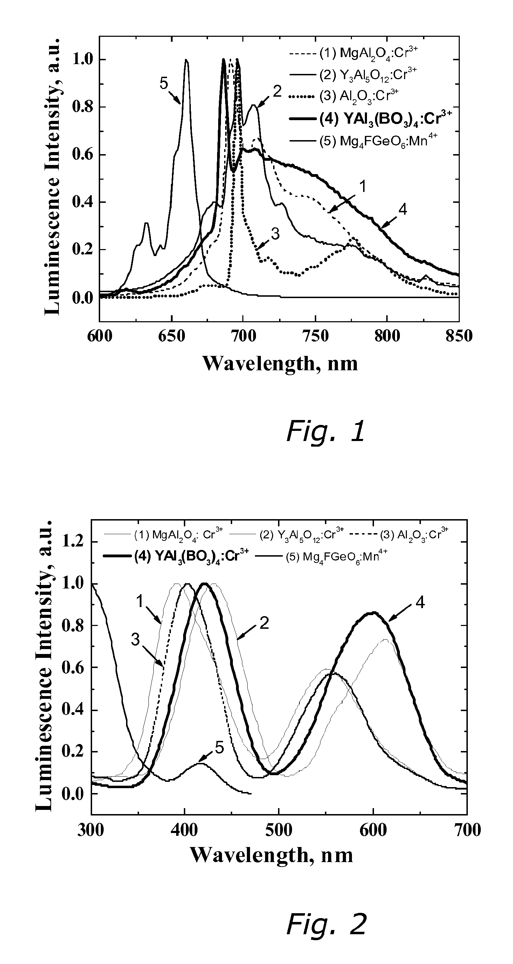

The emission and luminescence excitation spectra for Cr³+-doped YAB are shown in Fig. 1 and 2, respectively. The thermographic phosphor has intense broad luminescence in NIR region and additional sharp R-line. The emission spectra of other Cr³+-doped thermographic phosphors as well as of manganese(IV)-doped magnesium fluorogermanate are also shown in Fig. 1. Excitation of the Cr³+-doped YAB peaks at 421 and 599 nm. Notably, the Cr³+-doped YAB can be excited both in the blue and in the red part of the spectrum and is nicely compatible with the emission of the 635 nm red laser diode.

Cr³+-doped YAG (Y₃Al₅O₁₂) shows similar spectral features but much lower luminescence brightness. Other thermographic phosphors such as Cr³+-doped MgAl₂O₄ and Al₂O₃ as well as Mn⁴⁺-doped Mg₄FGe0₆ can not be efficiently excited in the red part of the spectrum.

The Cr³+-doped YABs were obtained in two different methods. In the first method the crystals are grown from the solution in high temperature flux potassium molybdate. This method results in high purity crystals however is rather slow. Moreover, micrometer-sized powders are strongly preferred for practical applications. Therefore, grinding of the crystals is advantageous.

On the other side, micrometer-sized powders can be directly obtained via the combustion route from the corresponding nitrates and boric acid. This method is easier to upscale and is less time consuming. However, it results in microcrystalls with small impurities of other phases with influence the properties of the phosphor to a minor extent.

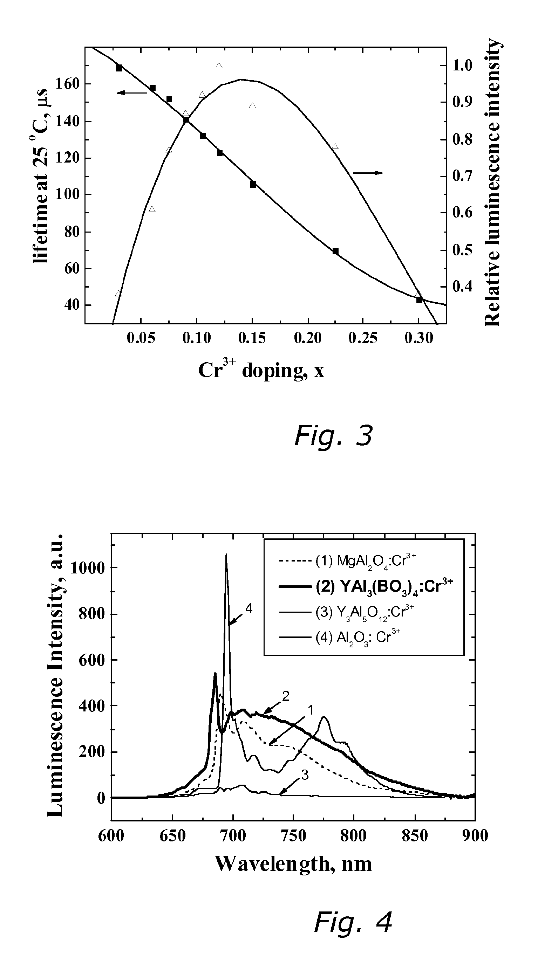

Fig. 3 shows dependences of the luminescence decay time and luminescence intensity on the amount of Cr³⁺ ions which substitute Al³⁺ in YAB. Evidently, concentration quenching is observed even at rather low concentration of Cr³⁺ which is indicated by the decrease in luminescence decay time. However, the luminescence intensity does increase with increasing of Cr³⁺ doping since the amount of the absorbed light becomes significantly higher. As can be seen (Fig. 3), the intensity drops after more than 4% of aluminum ions (x = 0.12) are substituted by chromium. Thus, YABs where 2-4% of aluminum is substituted can be a good compromise between luminescence brightness and the degree of concentration quenching.

Brightness of the Cr³⁺-doped YAB powder (x = 0.09) under 405 nm excitation was compared to the brightness of other thermographic phosphors. The phosphors powders were excited with at 405 nm and the emission spectra (corrected for the sensitivity of the photodetector) were compared (Fig. 4). The brightnesses relative to that of Mn⁴⁺-doped Mg₄FGeO₆ (= 1) were determined to be 0.47, 0.34, 0.32 and 0.04 for Cr³+-doped YAB, ruby, Cr³⁺-doped spinel and Cr³⁺-doped YAG, respectively. Evidently, Cr³⁺-doped YAB shows excellent brightness which is comparable to that of Mn⁴⁺-doped Mg₄FGO₆ (lamp phosphor).

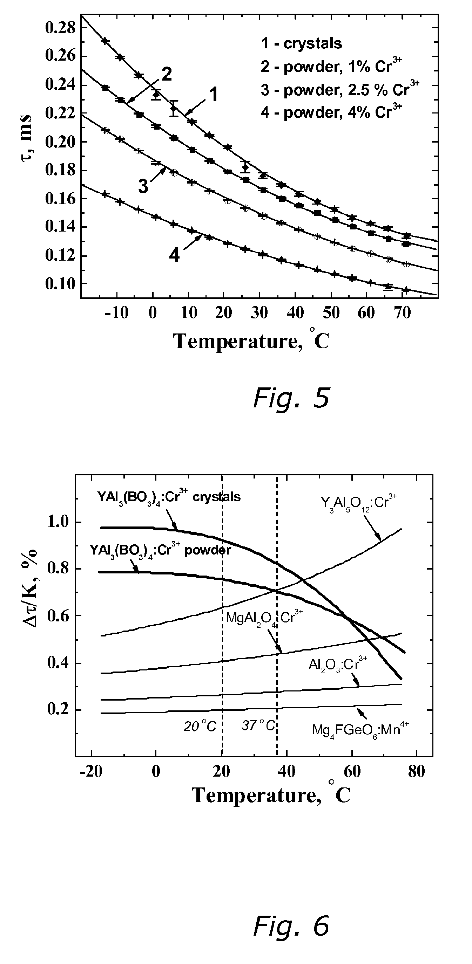

The luminescence decay time of Cr³⁺-doped YABs is highly temperature-dependent, which is the basis for its use as a thermographic phosphor (see Fig. 5). Generally, the crystals show the longest decay times and the highest temperature sensitivity approaching 1% of the lifetime change per 1 K. The decay time becomes slightly shorter if the crystals are ground into powder. This common phenomenon originates from inner defects in the crystal structure produced during grinding. Notably, the lifetime for the powders obtained via combustion route is less temperature-dependent (Fig. 5). For all Cr³+-doped YABs, temperature sensitivity is the highest at about 0 °C and becomes lower if the temperature increases. The most useful range is between -20°C to 100°C, preferably between -10°C to 45°C.

As clearly observed from Fig. 6, C^{r3}+-doped YAB shows much higher temperature sensitivity compared to other visible light-excitable phosphors. Cr³+-doped YAG could compete with YABs in term of temperature sensitivity, but its performance is compromised by low brightness. It should be emphasized that although other thermographic phosphors such as ruby and Mn⁴⁺-doped Mg₄FGeO₆ are rather established in room temperature thermometry, they provide 3-5 times poorer resolution than Cr³+-doped YAB.

In Cr³+-doped YAB yttrium can be partly substituted by lanthanum, gadolinium or lutetium, and aluminium can be partly substituted by scandium, indium or gallium. Partial substitution (less than 10%) has only a minor influence on the sensing properties of the thermographic phosphor. Therefore, the resulting phosphors can also be used for temperature measurements.

### Experimental:

Materials: Y₂O₃ (99.99%), Gd(NO₃)₃.6H₂O (99.9%), Cr(NO₃)₃.9H₂O (99%) and MoO₃ (99,5+%) were obtained from Aldrich (www.sigmaaldrich.com), Al(NO₃)₃.9H₂O (99+%), Y(NO₃)₃.6H₂O (99.9%), NH₂CONH₂ (99.5%) and Cr₂O₃ (99,997%) were from Fischer Scientific (www.fishersci.com), Al₂O₃ (>99%) - from Merck (www.merck.de), B₂O₃ (>99%) and K₂SO₄ (99+%) from Fluka (www.sigmaaldrich.com) and H₃BO₃ (99.99%) from ABCR (www.abcr.de). Mn(IV)-doped magnesium fluorogermanate was generously provided by OSRAM (Schwabmonchen). Microcrystalline powders of chromium(III)-doped YAG Y₃Al_{4.8}Cr_{0.2}O₁₂, spinel MgAl_{1.96}O_{0.04} and ruby Al_{1.96}Cr_{0.04}O₃ were obtained from the nitrates and urea using the solution combustion technique. The powders were sintered for 24 h at 1100°C in air.

### Example 1: Preparation of Cr(III)-doped YAB single crystals

The Cr(III)-doped YAB crystals were obtained by high temperature flux growth technique. The appropriate amounts of the oxides Y₂O₃, Al₂O₃, B₂O₃ and Cr₂O₃ were homogenized in a mortar and mixed with a flux system consisting of K₂SO₄ and MoO₃. The ratio of oxides to flux was 2:3 (w/w). The mixture was loaded in platinum crucibles and melted in a front loaded electric resistance furnace, equipped with programmable temperature controller. The temperature program consisted of heating to 1120°C at 300°C h⁻¹, keeping that temperature for 3 hours, and then slowly cooling down to 900°C at a rate of 1°C h⁻¹. Upon removing the flux by boiling in concentrated KOH (c = 8.0 M) YAB crystals (100 µm to 10 mm) were obtained. Whenever necessary the crystals were ground to microcrystalline powders in an agate mortar to a grain size of about 3 to 20 µm.

### Example 2: Preparation of Cr(III)-doped YAB microcrystalline powders

Microcrystalline YAB powders were synthesized employing the solution combustion method with urea as a fuel. Typically, 5 mmol (1.915 g) of Y(NO₃)₃.6H₂O, 13.5-14.85 mmol (5.064-5.570 g) of Al(NO₃)₃.9H₂O, 0.25-1.5 mmol (0.100-0.600 g) of Cr(NO₃)₃.9H₂O, 20 mmol (1.236 g) of H₃B0₃ and 100 mmol (6 g) of NH₂CONH₂ were dissolved in 10 mL deionised water. The solution was heated in a resistance furnace up to 500 °C (heating rate ∼20°C/min) and this temperature was kept for 15 minutes. The obtained raw material was milled in an agate mortar and sintered in a porcelain crucible for 24 h at 1100°C in air. The product was milled in a ball mill to obtain microcrystalline powders with a grain size of about 1 to 10 µm.

### Conclusion :

A new luminescent material (thermographic phosphor) exhibiting a temperature-dependent luminescence decay time based on chromium(III)-doped yttrium aluminium borate (YAB) is obtained as single crystals by high temperature flux growth and as a microcrystalline powder via solution combustion synthesis. The thermographic phosphor is excitable both in the blue (λₘₐₓ 421 nm) and in the red part of the spectrum (λₘₐₓ 599 nm) and shows bright NIR emission. The brightness of the phosphor is comparable to that of a well-known lamp phosphor Mn(IV)-doped magnesium fluorogermanate. At ambient temperatures, the Cr(III)-doped YAB shows high temperature dependence of the luminescence decay time which approaches 1%/K. The material shows no decrease in luminescence intensity at higher temperatures. The new thermographic phosphor is particularly promising for applications in temperature compensated optical chemosensors (including those based on NIR-emitting indicators) and in pressure-sensitive paints and coatings.

## Claims

1. A luminescent material exhibiting a temperature-dependent luminescence decay time,
**characterised in that**
the luminescent material comprises chromium(III) doped yttrium aluminium borate.

2. A luminescent material according to claim 1, **characterised in that** the material is based on solid state yttrium aluminium borate as a host matrix material with chromium(III) ions as dopant.

3. A luminescent material according to claim 1 or 2, **characterised in that** the luminescent material meets the chemical formula YAl₃-ₓCrₓ(BO₃)₄ with 0.03 ≤x ≤ 0.30, preferably 0.06 ≤ x ≤ 0.12.

4. A luminescent material according to claim 3, **characterised in that** less than 10% of yttrium ions are substituted by ions of lanthanum, gadolinium or lutetium.

5. A luminescent material according to claim 3, **characterised in that** less than 10% of aluminium ions are substituted by ions of gallium, indium or scandium.

6. A luminescent material according to any of claims 1 to 5, **characterised in that** the luminescent material is a single crystal material, preferably obtained by high temperature flux growth from an oxide mixture comprising at least Y₂O₃, Al₂O₃, B₂O₃ and Cr₂O₃.

7. A luminescent material according to claim 6, **characterised in that** the luminescent material is made of grinded crystal material having a grain size of about 3 to 20 µm.

8. A luminescent material according to any of claims 1 to 5, **characterised in that** the luminescent material is a micro crystalline powder, preferably obtained by a solution combustion synthesis, e.g. with urea as a fuel.

9. A luminescent material according to any of claims 1 to 8, **characterised in that** the luminescent material is excitable in the blue part (400 nm to 470 nm) and/or in the yellow-red part (540 nm to 660 nm) of an excitation spectrum and e.g. is excitable with the 635 nm emission line of a red laser diode.

10. Use of a luminescent material according to any of claims 1 to 9 as a temperature-sensitive component of a temperature-sensitive paint or coating.

11. Use of a luminescent material according to any of claims 1 to 9 as a temperature sensing component of a temperature-sensitive sensor.

12. Use of a luminescent material according to any of claims 1 to 9 for sensing of ambient temperatures, e.g. in a range of -20°C to 100°C, preferably -10°C to 45°C.
